# EUROPÄISCHE PATENTSCHRIFT

(11) **EP 1 980 007 B1**
(45) Veröffentlichungstag und Bekanntmachung des Hinweises auf die Patenterteilung: **04.05.2011**
(21) Anmeldenummer: 07701293.8
(22) Anmeldetag: 01.02.2007
(51) Int. Cl.: H02J 7/00

(54) **VERFAHREN UND ANORDNUNG ZUR VERÄNDERUNG DES LADE- UND GESUNDHEITSZUSTANDES (SOC, SOH) EINES AKKUMULATORS**
METHOD AND ARRANGEMENT FOR MODIFYING THE STATE OF CHARGE (SOC) AND STATE OF HEALTH (SOH) OF A BATTERY
DISPOSITIF ET PROCÉDÉ DE MODIFICATION DE L'ÉTAT DE CHARGE ET D'USURE (SOC, SOH) D'UN ACCUMULATEUR

(30) Priorität: 02.02.2006 AT 1632006; 07.08.2006 AT 13142006
(43) Veröffentlichungstag der Anmeldung: 15.10.2008
(73) Patentinhaber: Wieger, Martin, 7041 Wulkaprodersdorf (AT)
(72) Erfinder: Wieger, Martin, 7041 Wulkaprodersdorf (AT)
(74) Vertreter: Weiss, Christian
(86) Internationale Anmeldenummer: PCT/AT2007/000047
(87) Internationale Veröffentlichungsnummer: WO 2007/087662

(56) Entgegenhaltungen:
- EP-A- 0 831 571
- EP-A2- 0 662 744
- WO-A1-03/030331
- DE-A1- 10 128 637
- US-A- 5 701 068
- US-A- 5 828 201
- US-A- 6 014 013
- US-B1- 6 184 656
- US-B1- 6 504 344

## Beschreibung

Die Erfindung betrifft ein Verfahren zur Veränderung des Lade- und Gesundheitszustandes (SOC - state of charge, SOH - state of health) von mehrzelligen Akkumulatoren, wobei eine Zelle des mehrzelligen Akkumulators durch einen gesonderten elektrischen Strom beaufschlagt wird, wobei dieser Strom einem Arbeitsstrom des Akkumulators überlagert wird und dieser Strom auf diese eine Zelle zwecks Ladung dieser Zelle einwirkt, sowie eine Anordnung zur Durchführung des Verfahrens.

Eine Ladezustandsverbesserung bewirkt in erster Linie eine Erhöhung der Energiereserven des Akkumulators. Als Sekundäreffekt sinkt aber auch die Alterung bzw. der Verschleiß des Akkumulators je höher der Ladezustand ist bzw. je höher der Ladezustand gehalten wird. Ein geringer Ladezustand führt nämlich bekannter Weise zu einer schwer rückzuführenden Sulfatierung, wobei sulfatierte Bereiche des Akkumulators stärker verschleißen. Ein verbesserter Gesundheitszustand eines Akkumulators kann zum einen ebenfalls als Sekundäreffekt einer Ladezustandverbesserung angesehen werden. Zum anderen bewirkt aber auch eine Auflösung von so genannten Säureschichtungen eine Verbesserung des Gesundheitszustandes.

Als Elektrolyten kommen in Akkumulatoren häufig verdünnte Säuren, z.B. Schwefelsäure, zum Einsatz. Elektrolyt- bzw. Säureschichtungen, vornehmlich in horizontaler Ausrichtung, werden bei Akkumulatoren, wie z.B. Blei/Säure-Akkumulatoren, vornehmlich durch die Einwirkung der Schwerkraft auf den Elektrolyten generiert. Sie treten grundsätzlich immer auf, bereits fabrikneue Batterien weisen nach Abschluss der Produktion Säureschichtungen auf. Auch Akkumulatoren mit anderen Technologien zur Bindung des Elektrolyten (z.B. Gel oder AGM (Absorbend Glass Mat)) sowie Batterieausführungen in unterschiedlichen mechanischen Bauformen der Batterien bzw. Batteriezellen sind grundsätzlich davon betroffen, wenn auch nur im geringerem Ausmaß.

Die Säureschichtung wird später im Einsatz in ihrem Anwendungsbereich insbesondere durch Entladeprozesse ohne nachfolgende vollständige Wiederaufladung der Batterie verstärkt. Das Auftreten von Säureschichtungen führt primär zu einer signifikanten Reduktion der Leistungsfähigkeit des Akkumulators. Sekundär führt sie zu einer inhomogenen Abnutzung und Alterung der Platten einer Batterie, bedingt durch die höhere Säuredichte im unteren Bereich und die geringere Säuredichte im oberen Bereich der einzelnen Zellen der Batterie. Folgeschäden, wie z.B. Korrosion, Abschlammung und Sulfatierung und damit verbunden auch eine schnellere Alterung der Batterie resultieren weiters aus dem Umstand, dass die Säure in Batterien geschichtet ist.

Bedingt durch mehrere Gründe, insbesondere aber durch zunehmende
- zyklische Belastungen,
- nicht ausreichende Wiederaufladungen und
- eine feste mechanische Einbauweise der Platten
treten bei Akkumulatoren, wie Blei/Säure-Akkumulatoren, vornehmlich im Einsatzbereich von KFZ (Starterbatterien, Bordnetzbatterien), aber auch bei Batterien im Einsatz bei stationären Anlagen (USV-Anlagen, Solaranlagen, etc.) zunehmend Säureschichtungen auf. Als "nicht ausreichende Wiederaufladung" ist ein Ladungsvorgang dann zu bezeichnen, wenn entweder in Folge einer unzureichenden Ladespannung, einer zu kurzen Ladezeit oder einer zu geringen Mobilität der Ionen (z.B. bedingt durch tiefe Temperaturen) es zu keiner vollständigen Rückführung des gebildeten Entladungsproduktes (z.B. Bleisulfat bei verdünnter Schwefelsäure als Elektrolyt) kommt, aber unter Umständen auch, wenn die Ladung nicht ausreicht, um den Elektrolyten durch auftretende chemische Prozesse (insbesondere Gasung) zur Durchmischung und damit Beseitigung der Säureschichtung zu bringen. Der Vorgang der Durchmischung der Säure durch Gasblasenbildung in den Zellen eines Akkumulators funktioniert bekannter Weise dermaßen, dass der Elektrolyt durch die Aufwärtsbewegung der einzelnen Gasblasen bewegt (durchmischt) wird. Bedingt durch die Konzentration der Gasblasen im oberen Bereich der Zelle werden vorab die höher gelegen Teile des Elektrolyten bewegt. Erst bei fortschreitender Gasung über einen längeren Zeitraum werden auch die tiefer liegenden Bereiche der Zelle durchmischt.

Bekannte Verfahren zum Abbau der Säureschichtung basieren entweder auf einer konventionellen Ladung der Batterie oder auf einer gesondert generierten Methode zur Erzielung einer Bewegung (Umwälzung) des Elektrolyten.

Die bekannte Methode der konventionellen Ladung beruht darauf, dass mehr oder weniger große Zellbereiche zeitweise oder andauernd mit Spannungen über der jeweiligen Gasungsgrenze der verwendeten Batterietechnologie geladen werden. Eine solche Methode kann z.B. der DE 103 54 055 A1 oder der WO 2003/030331 A1 entnommen werden. Die sich daraus bildenden Reaktionsprodukte (vornehmlich Gasblasen) führen zur Ausbildung von Strömungsprofilen, die letztendlich zu einem Abbau der Schichtung des Elektrolyten führen. Solche Lademethoden (Gleich-, Wechselstrom- und Mischstromladeverfahren) sind in unterschiedlichen Ausgestaltungen aus dem Stand der Technik hinlänglich bekannt. Insbesondere bei Anwendung in KFZ, aber auch bei ortsfesten Anlagen, ergibt sich jedoch das Problem, dass in Folge einer vorgegebener Ladungsspannungsgrenze eine vollständige Aufladung (inklusive Abbau der Schichtung) nicht möglich ist. Ebenfalls als bekannt sind Einzelzellen-Ladungsverfahren, wie z.B. bei LilON-Akkumulatoren eingesetzt, anzusehen, die z.B. zur Überwachung und Begrenzung der

Ladespannung zur Vermeidung von Überspannungen (Explosionsgefahr) angewendet werden.

Daneben sind auch Schaltungen zur Strom- bzw. Spannungsaufteilung bei seriell und/oder parallel geschalteten Batterien, so genannte "Equaiizer", bekannt, z.B. aus der US 6 801 014 B. Solche Equalizer bewirken lediglich eine Symmetrierung des Ladestroms durch eine möglichst gleichförmige Aufteilung des Ladestroms oder der Ladespannung auf alle Batterien. Die Veränderung des Ladungszustands einzelner definierter Zellen, oder einzelner Batterien eines Batterieverbunds, ist bei Equalizerschaltungen aber unerwünscht, da ja ein Ausgleich über sämtliche Zellen oder Batterien angestrebt wird. An gesondert generierten Methoden zur Ausbildung eines Strömungsprofils zum Abbau der Elektrolytschichtung sind folgende Methoden bekannt:

### - Verwendung von Hilfselektroden

Durch Verwendung zusätzlicher Elektroden (Hilfselektroden) ist es möglich, zusätzlich zur allgemein ablaufenden Elektrodenreaktion des Akkumulators eine Gasblasenbildung zu erzeugen, wie z.B. in der US 20030148170 A1 oder der JP 62-139248 A2 beschrieben. Nachteil dieser Methode ist, dass eine zusätzliche Elektrode in den einzelnen Zellen des Akkumulators einzusetzen ist, welche hinsichtlich der Wechselwirkung der im Akkumulator stattfindenden elektrochemischen Prozesse entweder inert auszulegen ist, oder derart auszuführen ist, dass die elektrochemischen Prozesse nicht (negativ) beeinflusst werden.

### - Einblasen von Gasen

Durch entsprechende Öffnungen und Gaskanäle (Rohre) werden Gase (vornehmlich Umgebungsluft) in die Zellen eingeblasen. Die Austrittsorte des Gases liegen dabei vorzugsweise im unteren Bereich der Zellen, wie in der EP 620 605 A2 beschrieben. Es können damit aber auch ganze Austrittsbereiche abgedeckt werden, siehe z.B. JP 57-208 065 AA. Allen diesen Methoden ist gemeinsam, dass die Durchmischung durch eine, durch das eingebrachte Gas hervorgerufene Umwälzung des Elektrolyten bewirkt wird. Der Nachteil dieser Methoden besteht darin, dass damit ein zusätzlicher mechanischer Aufwand erforderlich ist und auch eine zusätzliche Fehlerquelle durch die Verwendung von Luftpumpen (Kompressoren) und Luftschläuchen gegeben ist. Zudem bedarf es entsprechender Belüftungsöffnungen, durch die das eingeblasene Gas wieder entweichen kann. Diese Öffnungen stellen potenziell undichte Stellen der Batterien dar. Der entweichende Luftstrom entnimmt zusätzlich der Batterie insbesondere bei höheren Temperaturen Feuchtigkeit, was den Wasserverbrauch der Batterie erhöht.

### - Einsatz von Elektrolytpumpen

Unter Verwendung entsprechender Rohrsysteme wird Elektrolyt aus Bereichen mit höherer Säuredichte abgepumpt (abgesaugt) und in Bereiche mit geringerer Säure wieder in die Zelle eingebracht, siehe z.B. US 20040067410 A1. Der Vorgang kann auch umgekehrt ausgeführt werden. Das dahinter stehende gemeinsame Funktionsprinzip ist die Erzeugung eines Strömungsprofils durch die Erzeugung einer künstlichen Bewegung des Elektrolyten, vorzugsweise verbunden damit, dass die Eintritts- und Austrittsöffnung in einer gewissen örtlichen Distanz angeordnet ist. Als Nachteile dieser Methode sind auch wieder der zusätzliche mechanische Aufwand und die Störungsanfälligkeit anzuführen.

### - Verwendung von inneren mechanischen Rührelementen

Bekannt ist auch die Verwendung mechanischer Rührelemente im Inneren der Batterie, die auch zu einer Durchwirbelung und damit Umwälzung des Elektrolyten führen, siehe z.B. JP 63-055852 AA. Nachteil dieses Verfahrens ist - neben dem zusätzlichen mechanischen Aufwand zur Installation des Rührelements - die Störungsanfälligkeit einer solchen Einheit.
- Verwendung sonstiger innerer Vorrichtungen zur Durchmischung des Elektrolyten Weiters können in Batterien mechanische Vorrichtungen zur Ausbildung eines Strömungsprofils, welche die grundsätzliche Bewegungsenergie aus einer äußeren Bewegung (z.B. Bewegung beim Einsatz in mobilen Anwendungen, Fahrzeugen) entnehmen, vorgesehen sein. Da aber die natürliche Bewegung bei Batterien in mobilen Anwendungen im Allgemeinen bekanntlich eher gering ist, liefern auch solche inneren Zusatzeinrichtungen zur Ausbildung spezieller Strömungsprofile nur eine sehr geringe Abhilfe.
- Verwendung äußerer mechanischer Vorrichtungen zur Durchmischung des Elektrolyten

Eine bessere Durchmischung des Elektrolyten kann grundsätzlich auch durch Vorrichtungen zur Herstellung einer äußeren Bewegung der Batterie (z.B. Rütteln oder Kippen) erzielt werden. Der Aufwand zur Bereitstellung einer entsprechenden Einrichtung ist insbesondere im Bereich mobiler Anwendungen (vornehmlich KFZ) schwer realisierbar. Zu dieser Gruppe der Elektrolytbewegung zählt auch die Durchmischung in Folge der natürlichen Fahrbewegungen beim Einsatz der Batterie in mobilen Anwendungen.

Zusammenfassend ist festzustellen, dass bei sämtlichen Methoden entsprechend dem Stand der Technik entweder der mechanische Aufwand verhältnismäßig hoch und eine zusätzliche Störanfälligkeit durch die Mechanik gegeben ist, oder der Nutzen des Verfahrens entsprechend gering ist.

Die US 6 504 344 B1 beschreibt ein Verfahren zur Bestimmung der Restkapazität einer Zelle eines Akkumulators, in dem die Zelle an einer Last zuerst entladen und danach wieder auf den Letztzustand aufgeladen wird. Weiters beschreibt die US 6 504 344 B1 ein Verfahren zur Verbesserung des Ladungszustandes, bei dem eine Zelle elektrisch von den restlichen Zellen isoliert wird und an dieser isolierten Zelle auf den Batterietyp abgestimmte Maßnahmen zur Verbesserung des Ladungszustandes gesetzt werden.

Aufgabe der vorliegenden Erfindung ist es nun, den Ladezustand eines Akkumulators zu ändern, vorzugsweise zu verbessern bzw. hoch zu halten, und weiters auftretende Elektrolytschichtungen rückzuführen bzw. das Auftreten von solchen Schichtungen von vornherein zu reduzieren, und damit alle bekannten Nachteile im Zusammenhang mit niedrigen Ladezuständen und Elektrolytschichtungen zumindest zu vermindern.

Diese Aufgabe wird erfindungsgemäß dadurch gelöst, dass die Zelle unter Einhaltung einer für den Akkumulator vorgegebene Ladungsspannungsgrenze mit einem elektrischen Strom beaufschlagt wird, der zur Gasung der Zelle und zu einem zu den restlichen Zellen abweichenden Ladungszustand der Zelle führt. Dies wird bei der erfindungsgemäßen Anordnung dadurch erreicht, dass an zumindest einer Zelle des mehrzelligen Akkumulators ein gesonderter elektrischer Anschluss vorgesehen ist, der aus dem Akkumulator herausgeführt ist, über den unter Einhaltung einer für den Akkumulator vorgegebene Ladungsspannungsgrenze ein gesonderter, dem Arbeitsstrom überlagerter elektrischer Strom eingeprägt werden kann, und dieser Strom auf diese zumindest eine Zelle zwecks Ladung dieser Zelle zur Erzeugung von Gasung der Zelle und zur Erzeugung eines zu den restlichen Zellen abweichenden Ladungszustand der Zelle einwirkt.

Durch Anwendung der Erfindung kann der Ladungszustand einer einzelnen Zelle und damit in Folge auch der Ladungszustand des gesamten Akkumulators gezielt beeinflusst, insbesondere erhöht oder erniedrigt, werden und es können Elektrolytschichtungen in Akkumulatoren rückgeführt bzw. reduziert oder sogar gänzlich vermieden werden, ohne die Nachteile der oben beschriebenen bekannten Methoden zum Abbau von Elektrolytschichtungen bei Akkumulatoren in Kauf nehmen zu müssen. Damit wird erreicht, dass die Leistungsfähigkeit des Akkumulators ohne Schichtung der Säure zurück gewonnen wird und das Auftreten sekundärer Schäden in Folge niedriger Ladungszustände und einer Säureschichtung vermieden werden kann. Insgesamt wird damit die Zuverlässigkeit des Akkumulators gesteigert und der Produktlebenszyklus kann verlängert werden.

Das erfindungsgemäße Verfahren weist dementsprechend gegenüber den Verfahren gemäß dem Stand der Technik den wesentlichen Vorteil auf, eine oder mehrere definierte Zelle(n) derart zu verändern, dass ein, von den restlichen Zellen abweichender Ladungszustand erzielt wird und damit der Ladungszustand des Akkumulators erhöht und Elektrolytschichtungen effizient und ohne das Auftreten von Wechselwirkungen mit dem Netz in dem der Akkumulator betrieben wird abgebaut werden können. Dies ist insbesondere dann von Bedeutung, wenn im Applikationsbereich der Batterie (Einsatz am Anwendungsort) die Bereitstellung einer ausreichenden Ladung (Ladung über Gasungsspannung, nach Maßgabe über einen, zur Durchmischung ausreichend langen Zeitraum) für die gesamte Batterie überhaupt nicht oder nur sehr schwierig bewerkstelligt werden kann.

Das Verfahren kann dabei darüber hinaus unabhängig von einem Arbeitsstrom (Verbraucher oder Ladestrom) durchgeführt werden, indem der einzuprägende Strom dem Arbeitsstrom des Akkumulators einfach überlagert wird.

Besonders vorteilhaft werden die Zellen des mehrzelligen Akkumulators in zumindest zwei Teileinheiten, bestehend aus jeweils zumindest einer Zelle, aufgeteilt, wobei zumindest eine Teileinheit mit einem elektrischen Strom zwecks Ladung oder Entladung der darin enthaltenen Zelle(n) beaufschlagt wird. Damit kann eine dem jeweiligen Einsatz des Akkumulators entsprechende Aufteilung und Beaufschlagung mit einem Strom gewährleistet werden. Das selbe Prinzip ist dabei auch auf einen Akkumulator, der aus einer Kombinationsschaltung aus mehreren einzelnen, seriell oder parallel verschalteten Teilakkumulatoren gebildet wird, anzuwenden.

Die Elektrolytschichtung im Akkumulator wird durch eine generierte Umwälzung des Elektrolyten, abgebaut, indem zumindest eine Zelle bzw. die Zellen einer Teileinheit mit einem elektrischen Strom beaufschlagt wird, der zur Gasung der Zelle(n) führt.

Je nach Anwendungsfall kann es vorteilhaft sein, alle Zellen bzw. alle Teileinheiten mit einem Strom zu beaufschlagen, unterschiedliche Zellen oder Teileinheiten mit unterschiedlichen elektrischen Strömen zu beaufschlagen, die unterschiedlichen elektrischen Ströme mit zumindest teilweise unterschiedlichen Richtungen einzuprägen und/oder Zellen oder Teileinheiten abwechselnd mit einem Strom zu beaufschlagen. Ebenfalls je nach Anwendungsfall können die eingeprägten elektrischen Ströme aus Gleich-, Wechsel- oder Mischströmen bestehen.

Das erfindungsgemäße Verfahren kann (zumindest während eines gewissen Zeitraumes) auch dann angewendet werden, wenn keine externe Stromversorgung vorhanden ist, indem die Energie zur Erzeugung des einzuprägenden Stromes bzw. der einzuprägenden Ströme dem Akkumulator entnommen wird. Der zur Bereitstellung dieser Energie erforderliche Strom ist dann in diesem Fall der Arbeitsstrom. Alternativ oder zusätzlich dazu kann die Energie auch über eine externe Spannungsversorgung zugeführt werden.

Das Vorhandensein zusätzlicher elektrischer Anschlüsse für eine Zelle oder Teileinheit kann einfach dazu benutzt werden, ein Monitoring des Batteriezustandes (SOC, SOH) und/oder ein Energiemanagement dieser Zellen oder Teileinheiten durchzuführen.

Die Auflösung von Elektrolytschichtungen kann unterstützt werden, indem der Akkumulator während der Beaufschlagung einer Zelle oder einer Teileinheit mit einem elektrischen Strom mechanisch bewegt wird oder einer zusätzlichen mechanischen Elektrolytumwälzung unterzogen wird.

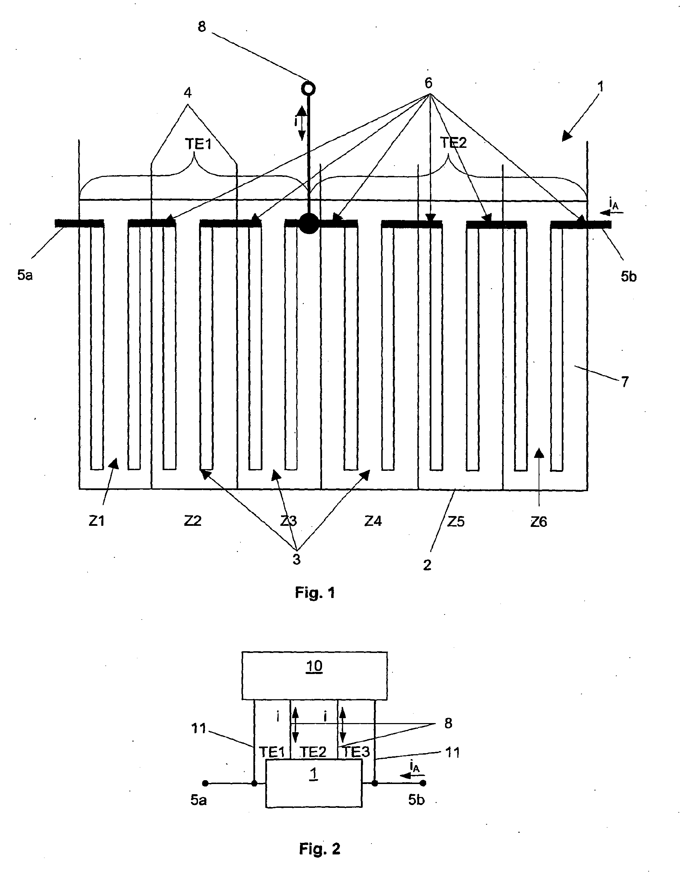

Die Erfindung wird im Nachfolgenden anhand der schematischen, beispielhaften und nicht einschränkenden Figuren 1 und 2 beschrieben. Dabei zeigt
Fig. 1 ein Akkumulator mit einer erfindungsgemäße Unterteilung der Zellen gruppiert in zwei Teileinheiten und
Fig. 2 ein Schaltschema einer erfindungsgemäßen Anordnung zur Verbesserung des Ladungszustandes einer Batterie.

Fig. 1 zeigt eine erfindungsgemäße Aufteilung des Akkumulators 1 in elektrische Teileinheiten TE1, TE2. Der Akkumulator, bzw. die Batterie, 1 besteht dabei wie hinlänglich bekannt aus einem Batteriekasten 2 der durch Zelltrennwände 4 in mehrere Zellen, hier sechs Zellen Z1 - Z6, unterteilt ist. In jeder Zelle Z1 - Z6 befindet sich ein Plattensatz 3, z.B. Bleiplatten, wobei die Plattensätze 3 durch Zellverbinder 6 elektrisch miteinander verbunden sind. Der Batteriekasten 2 ist dabei mit einem Elektrolyten 7, wie z.B. verdünnter Schwefelsäure, befüllt, der die Platten der Plattensätze 3 umgibt. Aus dem Batteriekasten 2 sind als elektrische Anschlüsse zwei Pole 5a und 5b herausgeführt. Durch den Akkumulator 1 fließt ein Arbeitsstrom i_{A}, also entweder ein Strom der dem Akkumulator 1 durch einen Verbraucher entnommen wird oder beim Laden in den Akkumulator 1 eingespeist wird. Ein solcher Aufbau einer Batterie 1 ist hinlänglich bekannt, weshalb hier darauf verzichtet wird näher darauf einzugehen.

Die Gesamteinheit des Akkumulators 1, im Sinne der vorhandenen Zellen Z1 - Zn, wird nun in elektrische Teileinheiten TE1 - TEn untergliedert. Die Maximalanzahl der möglichen elektrischen Unterteilungen entspricht der Zellenanzahl des Akkumulators 1, eine Teileinheit TE umfasst somit zumindest eine Zelle Z. Es kann z.B. eine 12V - Starterbatterie entsprechend der vorhandenen Anzahl von sechs Einzelzellen Z1 - Z6 in max. sechs elektrische Teileinheiten TE1 - TE6 aufgeteilt werden. Die minimale Anzahl der Aufteilungen ist eins, wie im vorliegenden Beispiel nach Fig. 1, bei dem die Batterie 1 einmal unterteilt wird, wobei folglich zwei Teileinheiten TE1, TE2 zu je drei Zellen Z1 - Z3 und Z4 - Z6 gebildet werden.

Jede aufgeteilte elektrische Teileinheit TE1, TE2 des Akkumulators 1 wird, z.B. an dem, die Teileinheiten TE1 und TE2 verbindenden Zellverbinder 6, mit einem gesonderten elektrischen Anschluss 8 versehen, der aus dem Akkumulator 1 herausgeführt wird und welcher die Einprägung eines gesonderten elektrischen Stromes i auf die jeweilige elektrische Teileinheit TE1, TE2, bzw. die jeweilige(n) Zelle(n) Z einer Teileinheit TE1, TE2, ermöglicht. Dieser Strom i ist dabei dem Arbeitsstrom i_{A} überlagert. Die primären Verbindungselemente des Akkumulators, wie Zellverbinder 6 und Pole 5a, 5b, müssen in ihrer Anordnung und Funktion dabei nicht verändert werden, was aber natürlich genauso möglich wäre.

Einzelne, dazu definierte elektrische Teileinheiten TE1, TE2 können mittels einer entsprechenden elektrischen Strom- bzw. Spannungsquelle mit einem elektrischen Strom i beaufschlagt werden. Der Strom i kann dabei ein Gleich-, Wechsel- oder Mischstrom sein. In den mit dem Strom i beaufschlagten definierten Teileinheiten TE1 und/oder TE2 werden damit elektrochemische Prozesse verursacht, die ausschließlich in dieser definierten Teileinheit TE1 und/oder TE2 ablaufen und die die restlichen, nicht beaufschlagten Teileinheiten zum Zeitpunkt der Beaufschlagung der definierten Teileinheiten TE1 und/oder TE2 nicht nennenswert beeinflussen oder verändern. Dabei kann die Beaufschlagung auf unterschiedliche Weise erfolgen, nämlich:
- derart, dass lediglich eine elektrische Teileinheit TE1 oder TE2 definiert wird, die mit einem Stromfluss i versehen wird,
- derart, dass alle elektrischen Teileinheiten TE1, TE2 definiert werden und mit einem Stromfluss i versehen werden,
- derart, dass definierte elektrische Teileinheiten TE1, TE2 mit einzelnen, unterschiedlichen Stromflüssen i beaufschlagt werden. Die Richtungen der Ströme i können bei unterschiedlichen definierten elektrischen Teileinheiten TE1, TE2 grundsätzlich auch voneinander abweichen, es kann also z.B. eine Zelle Z1 geladen werden, während eine andere Zelle Z6 gleichzeitig entladen wird,
- derart, dass definierte elektrische Teileinheiten TE1, TE2 abwechselnd mit einem Strom i beaufschlagt werden,
- derart, dass lediglich eine oder mehrere (alle) Teileinheiten TE1, TE2 für Messzwecke benutzt werden, also vorübergehend oder dauerhaft mit keinem Stromfluss i beaufschlagt werden, oder
- derart, dass sich der Stromfluss i (unabhängig von der Flussrichtung) einem, von einer externen Einrichtung (Verbraucher oder Ladequelle) eingeprägten Arbeitsstrom durch eine oder mehrere definierte Zelle(n) Z1 - Z6 überlagert und in seiner Wirkung verstärkt oder hemmt.

Das oben beschriebene Verfahren zielt also darauf ab, bei einer oder mehreren definierten Zelle(n) Z1 - Z6 in Relation zu den anderen Zellen des Akkumulators 1, bedingt durch das Einprägen von Stromflüssen i (Laden oder Entladen) unterschiedliche Ladezustände hervorzurufen, also auf eine singuläre Reaktion von Teileinheiten TE1, TE2 oder Einzelzellen. Es wird damit also möglich, einzelne Zellen Z oder Gruppen von Zellen (Teileinheiten TE1, TE2), unabhängig vom elektrochemischen Zustand des gesamten Akkumulators 1 zu laden, zu überladen bzw. auch zu entladen.

Die elektrischen Anschlüsse 8 können aber auch dazu verwendet werden, lediglich eine Beobachtung (Monitoring) der Teileinheiten TE1, TE2 , bzw. Einzelzellen Z1 - Z6 (z.B. zur Spannungsüberwachung) vorzusehen, deren Ergebnisse in direktem Zusammenhang mit der singulären Reaktion von Teileinheiten TE1, TE2 bzw. Einzelzellen Z1 - Z6 stehen (z.B. Bestimmung des Ladezustands, Ladezustandsverlauf, Lade- oder Entladeverlauf, etc.). Weiters bietet das erfindungsgemäße Verfahren auch die Möglichkeit, Auswertungen aus den Lade- und Entladeströmen und den erfassten Spannungen in Form eines Energiemanagement auf der Ebene (einer) einzelner(n) definierter(n) Zelle(n) oder Teileinheit zu nutzen (Einzelzellenmanagement).

Wird durch das beschriebene Verfahren eine oder mehrere definierte Zelle(n) (je nach Aufteilung der Batterie in Teileinheiten TE1, TE2) mit weiten Bereichen der Zelloberfläche in den Bereich der Gasungsspannung bzw. in darüber liegende Spannungsbereiche geführt, so ergibt sich daraus - im Vergleich zu den restlichen Zellen - die Ausbildung einer mehr oder weniger stark ausgeprägten Gasung dieser definierten Zelle(n). Insbesondere entsteht dadurch folglich die Möglichkeit zur Herstellung einer Gasungsreaktion, die zu einer Durchmischung der Säure und damit zu einem Abbau der Säureschichtung führt. Durch den damit erreichbaren hohen Ladezustand der definierten Zelle(n) wird gleichzeitig auch ein hoher Grad an Rückführung des Entladungsproduktes Bleisulfat (PbSO4) aus eventuell vorhandenen Bleisulfatschichten an den Platten erzielt, wofür sich das erfindungsgemäße Verfahren gleichermaßen gut eignet.

Das oben beschriebene Verfahren ist sinngemäß auch auf Verwendungszwecke anzuwenden, wo mehrere Batterien verschaltet (Serien- und oder Parallelschaltung) eingesetzt werden. Oftmals ist es nicht zulässig, die Gesamtspannung der Anlage - vor allem dauerhaft - über einer gewissen Grenze zu betreiben. Wohl aber ist es möglich, (eine) einzelne definierte Zelle(n) oder (eine) einzelne Batterie(n) (alle Zellen dieser sind dann definierte Zellen) mit höheren Spannungen (abwechselnd und/oder dauerhaft) zu betreiben.

Hilfreich dabei ist, entweder die Information über den Zustand (Spannungslage, SOC) der einzelnen definierten Zelle(n) zu kennen oder - in Kenntnis des grundlegenden Verhaltens des jeweiligen Akkumulators - ein Ablaufprogramm zur Steuerung der Beaufschlagung (einer) einzelnen(r) Zelle(n) zu generieren und die Batterie damit zu versehen.

Eine Anordnung zur Durchführung des oben beschriebenen Verfahrens ist beispielhaft in Fig. 2 dargestellt. Die hier dargestellte Anordnung weist eine Batterie 1 auf, die durch zwei gesonderte elektrische Anschlüsse 8 in drei Teileinheiten TE1, TE2, TE3, bestehend aus jeweils zumindest einer Zelle, unterteilt ist. Weiters ist eine Steuereinheit 10 vorgesehen, die mit den elektrischen Anschlüssen 8 und über Polanschlüsse 11 auch mit den beiden Polen 5a, 5b der Batterie 1 verbunden ist. Damit kann die Steuereinheit 10 durch eine entsprechende elektrische Schaltung jede Teileinheit TE1, TE2, TE3 separat oder (teilweise) kombiniert mit einem Strom i beaufschlagt, wofür in der Steuereinheit 10 eine entsprechende Strom- oder Spannungsquelle vorgesehen ist. Dieser Strom i kann unter Verwendung von einer externen, netzgebundenen (z.B. ein 230V Versorgungsnetz) sowie einer fahrzeugseitig bordnetzgebundenen (z.B. Lichtmaschine des KFZ) Spannungsversorgung 9 oder intern durch den Akkumulator 1 selbst erzeugt werden.

Bei Vorhandensein einer externen oder fahrzeugseitig bordnetzgebundenen Spannungsversorgung ist diese bevorzugt zur Erzeugung der Stromflüsse i in die definierte(n) Zellen(n) bzw. Teileinheiten TE1, TE2, TE3 zum Durchführung des erfindungsgemäßen Verfahrens zur Verbesserung des Lade- und Gesundheitszustandes zu verwenden (Strom- und Spannungsquelle).

Das erfindungsgemäße Verfahren kann aber auch zeitweise oder permanent ohne Vorhandensein einer externen, netzabhängigen oder fahrzeugseitig bordnetzgebundenen Spannungsversorgung durchgeführt werden. Von besonderer Bedeutung ist dabei der Einsatz bei mobilen Anwendungen. Dies trifft vornehmlich auf alle Einsatzgebiete von Akkumulatoren im Bereich von Starter- und Bordnetzbatterien für KFZ oder andere Fahrzeuge zu, aber auch bei Anwendungen, wo unsymmetrische Belastungen - bedingt entweder durch die Auslegung des Bordnetzes, oder durch eine unterschiedliche Alterung der eingesetzten Batterien (in der Praxis der Standardfall) - auftreten.

Eine Möglichkeit zur Erzeugung des erfindungsgemäßen Stromflusses zur Beeinflussung (einer) einzelnen(r) Zelle(n), bei Systemen ohne externe Spannungsversorgung, besteht darin, aus der vorhandenen Spannung (Bordnetzspannung, Betriebsspannung des Elektrofahrzeuges, etc.) mittels einer geeigneten Spannungswandlerschaltung, wie z.B. eine Gleichspannungswandlerschaltung mit oder ohne internen oder externen Wechselspannungszwischenkreis, Schaltungen zur Spannungsvervielfachung oder Spannungsteilung, diejenigen Ströme i (Lade- oder Entladeströme) herzustellen, die für die Beaufschlagung der definierten Zelle(n) Z oder Teileinheit(en) TE erforderlich sind.

Ebenso ist es möglich zur Erzeugung des erfindungsgemäßen Stromflusses zur Beeinflussung (einer) einzelnen(r) Zelle(n), mit oder ohne externer Spannungsversorgung, Schwingkreisschaltungen einzusetzen, in die die definierte(n) Zelle(n) Z oder Teileinheit(en) TE eingebunden sind. Die Funktion derartiger Schwingkreise kann beispielsweise auch darin bestehen, in der(n) definierte(n) Zelle(n) Z oder den Teileinheit(en) TE Überlagerungseffekte (Anhebungen, Abschwächungen) hervorzurufen, welche dann in Folge in diesen beaufschlagten Funktionseinheiten (neben der primären Ladung- oder Entladung) auch sekundäre Effekte, wie z.B. die Vermeidung unerwünschter oder die Erzielung erwünschter elektrochemischer Prozesse (Abscheidungs- oder Auflösungsprozesse, Wechselwirkungen chemischer Substanzen des Akkumulators) oder die Herbeiführung thermischer Prozesse (Erwärmung) bewirken.

Als ein konkretes Beispiel für eine Realisierung des erfindungsgemäßen Verfahrens wäre eine 12V-Starterbatterie für KFZ anzuführen. Die Schaltung zur Spannungsteilung kann z.B. mit einem DC/DC-Wandler realisiert werden, welcher eingangsspannnungsseitig aus dem Bordnetz des Fahrzeuges versorgt wird. Ausgangsseitig liefert der Wandler die, zur Manipulation an einer oder mehreren definierten Zellen oder Teileinheiten erforderlichen Ströme und Spannungen. Auch die umgekehrte Vorgangsweise, nämlich die Entnahme von Energie aus einer oder mehreren definierten Zelle(n) oder Teileinheit(en) (Entladung) und Einspeisung dieser Energie in das Bordnetz des Fahrzeuges ist möglich.

Als besonderer Vorteil dieser Methode, gleichgültig ob mit oder ohne externer Versorgung 9, ist anzuführen, dass auf diese Weise eine technische Möglichkeit geschaffen wird, eine oder mehrere definierte Zelle(n) einer Batterie 1 dermaßen mit Spannungen und Stromflüssen i zu versorgen, dass in ihr / in ihnen eine Gasung entsteht, welche zum nachhaltigen Abbau von Schichtungen des Elektrolyten 7 ausgenutzt werden können. Damit können sämtliche Folgen aus der Schichtung des Elektrolyten 7 a priori vermieden werden. Wechselwirkungen mit dem Fahrzeug oder dem Bordnetz des Fahrzeuges treten nur dann auf, wenn die Leerlaufspannung zuzüglich einem allfälligen Spannungshub an einer einzelnen Zelle oder an mehreren Zellen über die Bordnetzspannung (Reglerspannung) des Fahrzeuges steigt, wie dies z.B. bei stark entladenen Batterien und/oder einem Betrieb des Fahrzeuges im Modus der Unterladung (Generator des Bordnetzes kann den Gesamtenergieverbrauch sämtlicher Verbraucher nicht bereitstellen), bzw. auch bei einem Defekt am Generatorsystem erfolgen kann. Als einzige Konsequenz in einem dieser Fälle tritt jedoch lediglich der Zustand ein, dass - bei der Durchführung von Ladeprozessen an einer oder mehren einzelnen definierten Zelle(n) - erst nach Kompensation des Gesamtentladestroms, welcher aus der Batterie entnommen wird (Entladestrom) in voller Höhe durch die Steuereinheit 10 ein Stromfluss in Richtung Aufladung der definierten Zelle(n) oder Teileinheit(en) erreicht werden kann. Eine negative Beeinflussung des Bordnetzes tritt aber auch in diesem Fall nicht ein. Zweckmäßiger Weise wird die Funktion der Steuereinheit 10 unter einer gewissen Spannungsgrenze abzustellen sein, wobei dies keine Einschränkung des erfindungsgemäßen Verfahrens bzw. dessen Anordnung zur Durchführung darstellt.

Gleichermaßen stellt es keine Einschränkung des erfindungsgemäßen Verfahrens bzw. dessen Anordnung zur Durchführung dar, wenn die Versorgung der Steuereinheit 10 zur Bereitstellung der Stromflüsse i ausschließlich aus der Energie des Akkumulators 1 selbst aufgebracht wird. Aus praktischer Sicht kommt dieser Variante allerdings tendenziell eher eine untergeordnete Bedeutung zu.

## Patentansprüche

1. Verfahren zur Veränderung des Lade- und Gesundheitszustandes (SOC, SOH) von mehrzelligen Akkumulatoren (1), wobei eine Zelle (Z) des mehrzelligen Akkumulators (1) durch einen gesonderten elektrischen Strom (i) beaufschlagt wird, wobei dieser Strom (i) einem Arbeitsstrom (i_{A}) des Akkumulators überlagert wird und dieser Strom (i) auf diese eine Zelle (Z) zwecks Ladung dieser Zelle (Z) einwirkt, **dadurch gekennzeichnet, dass** die Zelle (Z) unter Einhaltung einer für den Akkumulator (1) vorgegebene Ladungsspannungsgrenze mit einem elektrischen Strom (i) beaufschlagt wird, der zur Gasung der Zelle (Z) und zu einem zu den restlichen Zellen abweichenden Ladungszustand der Zelle (Z) führt.

2. Verfahren nach Anspruch 1, **dadurch gekennzeichnet, dass** die Zellen (Z) des mehrzelligen Akkumulators (1) in zumindest zwei Teileinheiten (TE1, TE2), bestehend aus jeweils zumindest einer Zelle (Z), aufgeteilt werden und zumindest eine Teileinheit (TE1, TE2) mit einem elektrischen Strom (i) zwecks Ladung oder Entladung der darin enthaltenen Zelle(n) (Z) beaufschlagt wird.

3. Verfahren nach Anspruch 1 oder 2, **dadurch gekennzeichnet, dass** der Akkumulator (1) aus einer Kombinationsschaltung aus mehreren einzelnen, seriell oder parallel verschalteten Teilakkumulatoren gebildet wird und die Zellen (Z) des Akkumulators (1) in zumindest zwei Teileinheiten (TE1, TE2), bestehend aus jeweils zumindest einer Zelle (Z) des Akkumulators, aufgeteilt werden und zumindest eine Teileinheit (TE1, TE2) mit einem elektrischen Strom (i) zwecks Ladung der darin enthaltenen Zelle(n) (Z) beaufschlagt wird.

4. Verfahren nach Anspruch 3, **dadurch gekennzeichnet, dass** mehrere Teilakkumulatoren in zumindest zwei Teileinheiten (TE1, TE2), bestehend aus zumindest einer Zelle (Z), aufgeteilt werden und zumindest eine Teileinheit (TE1, TE2) mit einem elektrischen Strom (i) zwecks Ladung der darin enthaltenen Zelle(n) (Z) beaufschlagt wird.

5. Verfahren nach einem der Ansprüche 2 bis 4, **dadurch gekennzeichnet, dass** die Zelle(n) zumindest einer Teileinheit (TE1, TE2) mit einem elektrischen Strom (i) beaufschlagt werden, der zur Gasung der Zelle(n) (Z) führt.

6. Verfahren nach einem der Ansprüche 1 bis 5, **dadurch gekennzeichnet, dass** alle Zellen (Z) bzw. alle Teileinheiten (TE) mit jeweils einem unterschiedlichen Strom (i) beaufschlagt werden.

7. Verfahren nach einem der Ansprüche 1 bis 6, **dadurch gekennzeichnet, dass** unterschiedliche Zellen (Z) oder Teileinheiten (TE) mit unterschiedlichen elektrischen Strömen (i) beaufschlagt werden.

8. Verfahren nach Anspruch 7, **dadurch gekennzeichnet, dass** eine weitere Zelle mit einem weiteren elektrischen Strom beaufschlagt wird, des diese Zelle entlächt.

9. Verfahren nach einem der Ansprüche 1 bis 8, **dadurch gekennzeichnet, dass** zumindest zwei Zellen (Z) oder zumindest zwei Teileinheiten (TE) abwechselnd mit einem Strom (i) beaufschlagt werden.

10. Verfahren nach einem der Ansprüche 1 bis 9, **dadurch gekennzeichnet, dass** die eingeprägten elektrischen Ströme (i) aus Gleich-, Wechsel- oder Mischströmen bestehen.

11. Verfahren nach einem der Ansprüche 1 bis 10, **dadurch gekennzeichnet, dass** die Energie zur Erzeugung des einzuprägenden Stromes (i) bzw. der einzuprägenden Ströme dem Akkumulator (1) entnommen wird.

12. Verfahren nach einem der Ansprüche 1 bis 11, **dadurch gekennzeichnet, dass** die Energie zur Erzeugung des einzuprägenden Stromes (i) bzw. der einzuprägenden Ströme zumindest zeitweise über eine externe Spannungsversorgung zugeführt wird.

13. Verfahren nach einem der Ansprüche 1 bis 12, **dadurch gekennzeichnet, dass** der einzuprägende Strome (i) bzw. die einzuprägenden Ströme in einer Schwingkreisschaltung erzeugt werden.

14. Verfahren nach einem der Ansprüche 1 bis 13, **dadurch gekennzeichnet, dass** zusätzlich zur Einprägung eines elektrischen Stromes (i) in einzelne Zellen (Z) oder Teileinheiten (TE) ein Monitoring des Batteriezustandes (SOC, SOH) und/oder ein Energiemanagement dieser Zellen oder Teileinheiten durchgeführt wird.

15. Verfahren nach einem der Ansprüche 1 bis 14, **dadurch gekennzeichnet, dass** der Akkumulator (1) während der Beaufschlagung einer Zelle (Z) oder einer Teileinheit (TE) mit einem elektrischen Strom (i) mechanisch bewegt wird.

16. Verfahren nach einem der Ansprüche 1 bis 15, **dadurch gekennzeichnet, dass** der Akkumulator (1) während der Beaufschlagung einer Zelle (Z) oder einer Teileinheit (TE) mit einem elektrischen Strom (i) einer zusätzlichen mechanischen oder elektromagnetisch hervorgerufenen Elektrolytumwälzung unterzogen wird.

17. Anordnung zur Durchführung eines Verfahrens zur Veränderung des Lade- und Gesundheitszustandes (SOC, SOH) von mehrzelligen Akkumulatoren (1), **dadurch gekennzeichnet, dass** an zumindest einer Zelle (Z) des mehrzelligen Akkumulators (1) ein gesonderter elektrischer Anschluss (8) vorgesehen ist, der aus dem Akkumulator (1) herausgeführt ist und über den die Zelle (Z) unter Einhaltung einer für den Akkumulator vorgegebene Ladungsspannungsgrenze mit einem gesonderten, einem Arbeitsstrom (i_{A}) überlagerten elektrischen Strom (i) beaufschlagbar ist, und dieser Strom (i) auf diese zumindest eine Zelle (Z) zwecks Ladung dieser Zelle (Z) zur Erzeugung von Gasung der Zelle (Z) und zur Erzeugung eines zu den restlichen Zellen abweichenden Ladungszustand der Zelle (Z) einwirkt.

18. Anordnung nach Anspruch 17, **dadurch gekennzeichnet, dass** der mehrzellige Akkumulator (1) in zumindest zwei Teileinheiten (TE1, TE2), bestehend aus jeweils zumindest einer Zelle (Z) des Akkumulators (1), aufgeteilt wird und an einer dieser Teileinheiten (TE1, TE2) ein gesonderter elektrischer Anschluss vorgesehen ist, der aus dem Akkumulator (1) herausgeführt ist und über den die Teileinheit (TE1, TE2) mit einem gesonderten elektrischen Strom (i) zwecks Ladungbeaufschtagbar ist.

19. Anordnung nach Anspruch 17 oder 18, **dadurch gekennzeichnet, dass** mehrere einzelne Teilakkumulatoren seriell oder parallel zu einem Akkumulator (1) verschaltetet sind und der Akkumulator (1) in zumindest zwei Teileinheiten (TE1, TE2), bestehend aus jeweils zumindest einer Zelle (Z) des Akkumulators (1), aufgeteilt wird und an einer dieser Teileinheiten (TE1, TE2) ein gesonderter elektrischer Anschluss vorgesehen ist, der aus dem Akkumulator (1) herausgeführt ist und über den die Teileinheit (TE1, TE2) mit einem gesonderten elektrischen Strom (i) zwecks Ladungbeaufschlagbar ist.

20. Anordnung nach Anspruch 19, **dadurch gekennzeichnet, dass** mehrere Teilakkumulatoren in zumindest zwei Teileinheiten (TE1, ZE2), bestehend aus zumindest einer Zelle (Z), aufgeteilt werden und an einer dieser Teileinheiten (TE1, TE2) ein gesonderter elektrischer Anschluss vorgesehen ist, der aus dem Akkumulator (1) herausgeführt ist und über den die Teileinheit (TE1, TE2) mit einem gesonderten elektrischen Strom (i) zwecks Ladungbeaufschlagbar ist.

21. Anordnung nach einem der Ansprüche 17 bis 20, **dadurch gekennzeichnet, dass** an jeder Zelle (Z) oder jeder Teileinheit (TE1, TE2) ein gesonderter elektrischer Anschluss vorgesehen ist, der aus dem Akkumulator (1) herausgeführt ist und über den jede einzelne Zelle (Z) oder jede einzelne Teileinheit (TE1, TE2) mit einem unterschiedlichen elektrischen Strom (i) beaufschlagt werden.

22. Anordnung nach einem der Ansprüche 17 bis 21, **dadurch gekennzeichnet, dass** eine Schwingkreisschaltung vorgesehen ist, in die die zu beaufschlagende(n) Zelle(n) (Z) oder Teileinheit(n) (TE1, TE2) eingebunden ist (sind).

23. Anordnung nach einem der Ansprüche 17 bis 22, **dadurch gekennzeichnet, dass** eine Steuereinheit (10) zur Erzeugung des einzuprägenden elektrischen Stromes (i) vorgesehen ist, die mit dem gesonderten elektrischen Anschluss (8) bzw. den gesonderten elektrischen Anschlüssen verbunden ist.

24. Anordnung nach Anspruch 23, **dadurch gekennzeichnet, dass** die Steuereinheit (10) mit den beiden Polen (5a, 5b) des Akkumulators (1) verbunden ist.

25. Anordnung nach Anspruch 23 oder 24, **dadurch gekennzeichnet, dass** die Steuereinheit (10) die Energie zur Erzeugung des einzuprägenden elektrischen Stromes (i) bzw. der einzuprägenden elektrischen Ströme dem Akkumulator (1) entnimmt.

26. Anordnung nach Anspruch 23, 24 oder 25, **dadurch gekennzeichnet, dass** an der Steuereinheit (10) ein Anschluss für eine externe Spannungsversorgung vorgesehen ist.

27. Anordnung nach einem der Ansprüche 17 bis 26, **dadurch gekennzeichnet, dass** eine Monitoring- und/oder eine Energiemanagementeinheit vorgesehen ist.

28. Anordnung nach einem der Ansprüche 17 bis 27, **dadurch gekennzeichnet, dass** eine Einrichtung zum mechanischen Bewegen des Akkumulator (1) während der Beaufschlagung einer Zelle (Z) oder einer Teileinheit (TE) mit einem elektrischen Strom (i) vorgesehen ist.

29. Anordnung nach einem der Ansprüche 17 bis 28, **dadurch gekennzeichnet, dass** im Akkumulator (1) bzw. in einem Teilakkumulator eine Umwälzeinrichtung zur mechanischen oder elektromagnetisch hervorgerufenen Elektrolytumwälzung während der Beaufschlagung einer Zelle (Z) oder einer Teileinheit (TE) mit einem elektrischen Strom (i) vorgesehen ist.

## Claims

1. Method for changing the state of charge and state of health (SOC, SOH) of multicell batteries (1), wherein a cell (Z) of the multicell battery (1) is acted on by a separate electrical current (i), this current (i) being superimposed on a working current (iA) of the battery, and this current (i) acting on this one cell (Z) for the purpose of charging this cell (Z), **characterized in that** the cell (Z), while maintaining a charge voltage limit specified for the battery (1), is acted on by an electrical current (i), resulting in gassing of the cell (Z) and a charge state of the cell (Z) which is different from the remaining cells.

2. Method according to Claim 1, **characterized in that** the cells (Z) of the multicell battery (1) are divided into at least two subunits (TE1, TE2), each comprising at least one cell (Z), and at least one subunit (TE1, TE2) is acted on by an electrical current (i) for the purpose of charging or discharging the cell(s) (Z) contained therein.

3. Method according to Claim 1 or 2, **characterized in that** the battery (1) is formed from a combination circuit composed of multiple individual partial batteries connected in series or in parallel, and the cells (Z) of the battery (1) are divided into at least two subunits (TE1, TE2), each comprising at least one cell (Z) of the battery, and at least one subunit (TE1, TE2) is acted on by an electrical current (i) for the purpose of charging the cell(s) (Z) contained therein.

4. Method according to Claim 3, **characterized in that** multiple partial batteries are divided into at least two subunits (TE1, TE2) comprising at least one cell (Z), and at least one subunit (TE1, TE2) is acted on by an electrical current (i) for the purpose of charging the cell(s) (Z) contained therein.

5. Method according to one of Claims 2 through 4, **characterized in that** the cell(s) of at least one subunit (TE1, TE2) is/are acted on by an electrical current (i), resulting in gassing of the cell(s) (Z).

6. Method according to one of Claims 1 through 5, **characterized in that** all cells (Z) or all subunits (TE) are in each case acted on by a different current (i).

7. Method according to one of Claims 1 through 6, **characterized in that** different cells (Z) or subunits (TE) are acted on by different electrical currents (i).

8. Method according to Claim 7, **characterized in that** a further cell is acted on by a further electrical current which discharges this cell.

9. Method according to one of Claims 1 through 8, **characterized in that** at least two cells (Z) or at least two subunits (TE) are acted on in alternation by a current (i).

10. Method according to one of Claims 1 through 9, **characterized in that** the applied electrical currents (1) comprise direct currents, alternating currents, or mixed currents.

11. Method according to one of Claims 1 through 10, **characterized in that** the power for generating the current to be applied (i) or the currents to be applied is withdrawn from the battery (1).

12. Method according to one of Claims 1 through 11, **characterized in that** the energy for generating the current to be applied (i) or the currents to be applied is supplied, at least temporarily, via an external power supply.

13. Method according to one of Claims 1 through 12, **characterized in that** the current to be applied (i) or the currents to be applied is/are generated in an oscillating circuit.

14. Method according to one of Claims 1 through 13, **characterized in that** in addition to applying an electrical current (i) to individual cells (Z) or subunits (TE), monitoring of the battery state (SOC, SOH) and/or energy management of these cells or subunits is/are carried out.

15. Method according to one of Claims 1 through 14, **characterized in that** the battery (1) is mechanically moved by an electrical current (i) while a cell (Z) or a subunit (TE) is acted on.

16. Method according to one of Claims 1 through 15, **characterized in that** the battery (1) undergoes additional electrolyte circulation caused by mechanical or electromagnetic means while a cell (Z) or a subunit (TE) is acted on by an electrical current (i).

17. System for carrying out a method for changing the state of charge and state of health (SOC, SOH) of multicell batteries (1), **characterized in that** at at least one cell (Z) of the multicell battery (1) a separate electrical connection (8) is provided which leads out from the battery (1) and via which the cell (Z), while maintaining a charge voltage limit specified for the battery, may be acted on by a separate electrical current (i) which is superimposed on a working current (iA), and this current (i) acts on this at least one cell (Z) for the purpose of charging this cell (Z) for producing gassing of the cell (Z) and for producing a charge state of the cell (Z) which is different from the remaining cells.

18. System according to Claim 17, **characterized in that** the multicell battery (1) is divided into at least two subunits (TE1, TE2), each comprising at least one cell (Z) of the battery (1), and at one of these subunits (TE1, TE2) a separate electrical connection is provided which leads out from the battery (1) and via which the subunit (TE1, TE2) may be acted on by a separate electrical current (i) for the purpose of charging.

19. System according to Claim 17 or 18, **characterized in that** multiple individual partial batteries are connected in series or in parallel to a battery (1), and the battery (1) is divided into at least two subunits (TE1, TE2), each comprising at least one cell (Z) of the battery (1), and at one of these subunits (TE1, TE2) a separate electrical connection is provided which leads out from the battery (1) and via which the subunit (TE1, TE2) may be acted on by a separate electrical current (i) for the purpose of charging.

20. System according to Claim 19, **characterized in that** multiple partial batteries are divided into at least two subunits (TE1, TE2) comprising at least one cell (Z), and at one of these subunits (TE1, TE2) a separate electrical connection is provided which leads out from the battery (1) and via which the subunit (TE1, TE2) may be acted on by a separate electrical current (i) for the purpose of charging.

21. System according to one of Claims 17 through 20, **characterized in that** at each cell (Z) or each subunit (TE1, TE2) a separate electrical connection is provided which leads out from the battery (1) and via which each individual cell (Z) or each individual subunit (TE1, TE2) is acted on by a different electrical current (i).

22. System according to one of Claims 17 through 21, **characterized in that** an oscillating circuit is provided, into which the cell(s) (Z) or subunit(s) (TE1, TE2) to be acted on is/are integrated.

23. System according to one of Claims 17 through 22, **characterized in that** a control unit (10) is provided for generating the electrical current (i) to be applied, and is connected to the separate electrical connection (8) or the separate electrical connections.

24. System according to Claim 23, **characterized in that** the control unit (10) is connected to the two terminals (5a, 5b) of the battery (1).

25. System according to Claim 23 or 24, **characterized in that** the control unit (10) withdraws the power for generating the electrical current (i) to be applied, or the electrical currents to be applied, from the battery (1).

26. System according to Claim 23, 24, or 25, **characterized in that** a connection for an external power supply is provided at the control unit (10).

27. System according to one of Claims 17 through 26, **characterized in that** a monitoring unit and/or an energy management unit is/are provided.

28. System according to one of Claims 17 through 27, **characterized in that** a unit is provided for mechanically moving the battery (1) while a cell (Z) or a subunit (TE) is acted on by an electrical current (i).

29. System according to one of Claims 17 through 28, **characterized in that** a circulation unit for electrolyte recirculation caused by mechanical or electromagnetic means while a cell (Z) or a subunit (TE) is acted on by an electrical current (i) is provided in the battery (1) or in a partial battery.

## Revendications

1. Procédé de modification de l'état de charge et d'usure (SOC, SOH) d'accumulateurs multi-cellules (1), une cellule (Z) de l'accumulateur multi-cellules (1) recevant un courant électrique séparé (i), ce courant (i) étant superposé à un courant de travail (iA) de l'accumulateur et ce courant (i) agissant sur cette cellule (Z) pour la charge de cette cellule (Z), **caractérisé par le fait que** la cellule (Z) reçoit un courant électrique (i) avec maintien d'une limite de tension de charge prédéfinie pour l'accumulateur (1), courant qui conduit à la gazéification de la cellule (Z) et à un état de charge de la cellule (Z) s'écartant des cellules restantes.

2. Procédé selon la revendication 1, **caractérisé par le fait que** les cellules (Z) de l'accumulateur multi-cellules (1) sont divisées en au moins deux unités partielles (TE1, TE2), se composant à chaque fois d'au moins une cellule (Z), et au moins une unité partielle (TE1, TE2) reçoit un courant électrique (i) pour la charge ou la décharge de la ou des cellule(s) qui y sont contenues.

3. Procédé selon l'une des revendications 1 ou 2, **caractérisé par le fait que** l'accumulateur (1) est formé d'un circuit combiné de plusieurs accumulateurs partiels, montés en série ou en parallèle,individuels, et les cellules (Z) de l'accumulateur (1) sont divisées en au moins deux unités partielles (TE1, TE2), se composant à chaque fois d'au moins une cellule (Z) de l'accumulateur, et au moins une unité partielle (TE1, TE2) reçoit un courant électrique (i) pour la charge de la ou des cellules (Z) qui y sont contenues.

4. Procédé selon la revendication 3, **caractérisé par le fait que** plusieurs accumulateurs partiels sont divisés en au moins deux unités partielles (TE1, TE2), se composant d'au moins une cellule (Z), et au moins une unité partielle (TE1, TE2) reçoit un courant électrique (i) pour la charge de la ou des cellules (Z) qui y sont contenues.

5. Procédé selon l'une des revendications 2 à 4, **caractérisé par le fait que** la ou les cellules d'au moins une unité partielle (TE1, TE2) reçoivent un courant électrique (i), lequel conduit à la gazéification de la ou des cellules (Z).

6. Procédé selon l'une des revendications 1 à 5, **caractérisé par le fait que** toutes les cellules (Z) ou toutes les unités partielles (TE) reçoivent à chaque fois un courant (i) différent.

7. Procédé selon l'une des revendications 1 à 6, **caractérisé par le fait que** des cellules (Z) ou unités partielles (TE) différentes reçoivent des courants électriques (i) différents.

8. Procédé selon la revendication 7, **caractérisé par le fait qu'**une autre cellule reçoit un autre courant électrique, lequel décharge cette cellule.

9. Procédé selon l'une des revendications 1 à 8, **caractérisé par le fait qu'**au moins deux cellules (Z) ou au moins deux unités partielles (TE) reçoivent tour à tour un courant (i).

10. Procédé selon l'une des revendications 1 à 9, **caractérisé par le fait que** les courants électriques appliqués (i) se composent de courants continus, alternatifs ou mixtes.

11. Procédé selon l'une des revendications 1 à 10, **caractérisé par le fait que** l'énergie pour la production du courant (i) à appliquer ou des courants à appliquer est extraite de l'accumulateur (1).

12. Procédé selon l'une des revendications 1 à 11, **caractérisé par le fait que** l'énergie pour la production du courant (i) à appliquer ou des courants à appliquer est amenée au moins par moments par une alimentation en tension externe.

13. Procédé selon l'une des revendications 1 à 12, **caractérisé par le fait que** le courant (i) à appliquer ou les courants à appliquer sont produits dans un circuit oscillant.

14. Procédé selon l'une des revendications 1 ou 13, **caractérisé par le fait qu'**en plus de l'application d'un courant électrique (i) dans des cellules individuelles (Z) ou des unités partielles individuelles (TE), une surveillance de l'état de la batterie (SOC, SOH) et/ou une gestion de l'énergie de ces cellules ou unités partielles sont conduites.

15. Procédé selon l'une des revendications 1 à 14, **caractérisé par le fait que** l'accumulateur (1) est déplacé mécaniquement pendant l'application d'un courant électrique (i) à une cellule (Z) ou à une unité partielle (TE).

16. Procédé selon l'une des revendications 1 à 15, **caractérisé par le fait que** l'accumulateur (1) est soumis à une circulation d'électrolyte additionnelle mécanique ou provoquée électromagnétiquement pendant l'application d'un courant électrique (i) à une cellule (Z) ou à une unité partielle (TE).

17. Dispositif pour la mise en oeuvre d'un procédé de modification de l'état de charge et d'usure (SOC, SOH) d'accumulateurs multi-cellules (1), **caractérisé par le fait que**, sur au moins une cellule (Z) de l'accumulateur multi-cellules (1), est prévue une connexion électrique séparée (8) qui est conduite en dehors de l'accumulateur (1) et par l'intermédiaire de laquelle la cellule (Z) avec maintien d'une limite de tension de charge prédéfinie pour l'accumulateur reçoit un courant électrique séparé (i), superposé à un courant de travail (iA) et ce courant (i) agit sur cette au moins une cellule (Z) pour la charge de cette cellule (Z), pour la production de la gazéification de la cellule (Z) et pour la production d'un état de charge de la cellule (Z) s'écartant des cellules restantes.

18. Dispositif selon la revendication 17, **caractérisé par le fait que** l'accumulateur multi-cellules (1) est divisé en au moins deux unités partielles (TE1, TE2), se composant chacune d'au moins une cellule (Z) de l'accumulateur (1), et, sur l'une de ces unités partielles (TE1, TE2), est prévue une connexion électrique séparée qui est conduite en dehors de l'accumulateur (1) et par l'intermédiaire de laquelle l'unité partielle (TE1, TE2) reçoit un courant électrique séparé (i) pour la charge.

19. Dispositif selon l'une des revendications 17 ou 18, **caractérisé par le fait que** plusieurs accumulateurs partiels sont montés en série ou en parallèle en un accumulateur (1), et que l'accumulateur (1) est divisé en au moins deux unités partielles (TE1, TE2), se composant à chaque fois d'au moins une cellule (Z) de l'accumulateur (1), et, sur l'une de ces unités partielles (TE1, TE2), est prévue une connexion électrique séparée, qui est conduite en dehors de l'accumulateur (1) et par l'intermédiaire de laquelle l'unité partielle (TE1, TE2) est apte à recevoir un courant électrique séparé (i) pour la charge.

20. Dispositif selon la revendication 19, **caractérisé par le fait que** plusieurs accumulateurs partiels sont divisés en au moins deux unités partielles (T1, T2) se composant d'au moins une cellule (Z), et sur l'une de ces unités partielles (TE1, TE2) est prévue une connexion électrique séparée, qui est conduite en dehors de l'accumulateur (1) et par l'intermédiaire de laquelle l'unité partielle (TE1, TE2) est apte à recevoir un courant électrique séparé (i) pour la charge.

21. Dispositif selon l'une des revendications 17 à 20, **caractérisé par le fait que**, sur chaque cellule (Z) ou chaque unité partielle (TE1, TE2), est prévue une connexion électrique séparée, qui est conduite en dehors de l'accumulateur (1) et par l'intermédiaire de laquelle chaque cellule individuelle (Z) ou chaque unité partielle individuelle (TE1, TE2) reçoit un courant électrique (i) différent.

22. Dispositif selon l'une des revendications 17 à 21, **caractérisé par le fait qu'**un circuit oscillant est prévu, dans lequel la ou les cellules (Z) ou la ou les unités partielles (TE1, TE2) devant recevoir un courant est ou sont incorporées.

23. Dispositif selon l'une des revendications 17 à 22, **caractérisé par le fait qu'**une unité de commande (10) est prévue pour la production d'un courant électrique (i) à appliquer, qui est reliée avec la connexion électrique séparée (8) ou avec les connexions électriques séparées.

24. Dispositif selon la revendications 23, **caractérisé par le fait que** l'unité de commande (10) est reliée aux deux pôles (5a, 5b) de l'accumulateur (1).

25. Dispositif selon l'une des revendications 23 ou 24, **caractérisé par le fait que** l'unité de commande (10) extrait de l'accumulateur (1) l'énergie pour la production du courant électrique (i) à appliquer ou des courants électriques à appliquer.

26. Dispositif selon l'une des revendications 23, 24 ou 25, **caractérisé par le fait que**, sur l'unité de commande (10), est prévue une connexion pour une alimentation en tension externe.

27. Dispositif selon l'une des revendications 17 à 26, **caractérisé par le fait qu'**une unité de surveillance et/ou de gestion d'énergie est prévue.

28. Dispositif selon l'une des revendications 17 à 27, **caractérisé par le fait qu'**un dispositif pour le déplacement mécanique de l'accumulateur (1) pendant l'application d'un courant électrique (i) à une cellule (Z) ou à une unité partielle (TE) est prévu.

29. Dispositif selon l'une des revendications 17 à 28, **caractérisé par le fait que**, dans l'accumulateur (1) ou dans un accumulateur partiel, un dispositif de circulation pour la circulation d'électrolyte mécanique ou provoquée électromagnétiquement pendant l'application d'un courant électrique (i) à une cellule (Z) ou une unité partielle (TE), est prévu.
